Europäisches Patentamt

European Patent Office

Office européen des brevets

(19)

(11) Veröffentlichungsnummer: **0 451 351 A1**

# (12) EUROPÄISCHE PATENTANMELDUNG

(21) Anmeldenummer: 90123729.7

(22) Anmeldetag: 10.12.90

(51) Int. Cl.5: **C23C 14/54**, C23C 16/46

(30) Priorität: 09.04.90 DE 4011460

(43) Veröffentlichungstag der Anmeldung:
16.10.91 Patentblatt 91/42

(84) Benannte Vertragsstaaten:
**DE FR GB IT**

(71) Anmelder: **LEYBOLD AKTIENGESELLSCHAFT**
**Wilhelm-Rohn-Strasse 25**
**W-6450 Hanau am Main 1(DE)**

(72) Erfinder: **Gegenwart, Rainer, Dr.**

Bruchwiesenstrasse 69a
W-6074 Roedermark(DE)
Erfinder: **Katzschner, Werner, Dipl.-Ing.**
Am Wingert 18
W-8752 Kleinkahl(DE)
Erfinder: **Lorenz, Gerhard, Dipl.-Ing.**
Taunusring 39
W-8755 Alzenau(DE)
Erfinder: **Stoll, Helmut, Dipl.-Ing.**
Eschborner Strasse 22
W-6231 Sulzbach(DE)

(54) **Vorrichtung zum direkten Beheizen eines Substratträgers.**

(57) Vorrichtung zum Beheizen eines Substratträgers (5) mit Hilfe einer elektrischen Widerstandsheizung in einer Anlage zur Behandlung von Substraten (7) unter Vakuum, wobei das Heizelement (7) direkt am Substratträger (5) angeordnet und über korrespondierende Kontakte - beispielsweise einen Kontaktstift (2) mit einer Kontaktbuchse (6) - elektrisch mit einer an der Konsole (1) vorgesehenen Stromversorgung verbindbar ist, wozu der Substratträger (5) vorzugsweise auf der Oberseite der Konsole (1) mit einer nicht näher definierten Hubvorrichtung absetzbar ist.

Die Erfindung betrifft eine Vorrichtung zum Beheizen eines Substratträgers mit Hilfe einer elektrischen Widerstandsheizung in einer Anlage zur Behandlung von Substraten unter Vakuum.

Bekannt ist ein Verfahren zur Behandlung eines Gegenstandes in einer Vakuumkammer unter Vakuum (EP 0 025 670). Hierbei wird ein Gegenstand auf einem Träger an einer Behandlungsstation positioniert und ein Gas zwischen dem Gegenstand und dem Träger zur Leitung von Wärme zwischen dem Gegenstand und dem Träger vorgesehen, wobei der Gegenstand bei diesem Verfahren nur indirekt geheizt bzw. gekühlt wird.

Weiterhin ist ein anderes Verfahren zum Heizen eines Gegenstandes (Substrats) unter Vakuum allgemein bekannt, bei dem eine Induktionsheizung eingesetzt wird. Hierbei wirkt der Substratträger als niederohmige Sekundärwicklung.

Dieses zuerst benannte Verfahren hat den Nachteil, daß bei zu hohem Druck des wärmeleitenden Gases zu viel Wärme durch Konvektion zu den Wänden der Vakuumkammer abgeführt wird und daß eine relativ lange Zeitspanne benötigt wird, bis der Temperaturausgleich zwischen dem Gegenstand (Substrat) und dem Träger stattgefunden hat.

Das als zweites benannte Verfahren hat den Nachteil, daß es zwar prinzipiell anwendbar, aber jedoch nicht bei mit Hochfrequenz (Radiofrequenz = RF) betriebenen Plasmaätz- und -beschichtungsanlagen unter Vakuum einsetzbar ist, da in diesem Anwendungsfalle der Substratträger selbst als eine an RF angeschlossene Kathode eingesetzt wird und die durch die RF eingebrachte Energie ebenso in Wärme umgesetzt wird und somit kein kontrollierbarer, getrennter Einsatz von Heizung und RF möglich ist. Zudem würden die durch die Induktionsheizung erzeugten Magnetfelder zu einer ungleichmäßigen Verteilung der Ladungsträger im Plasma vor den Substraten führen.

Der Erfindung liegt deshalb die Aufgabe zugrunde, ein Verfahren bzw. eine Vorrichtung zu finden, die ein einfaches, sicheres, schnelles und kontrollierbares Heizen eines Substratträgers und somit eines auf den Substratträger aufzulegenden Substrats ermöglicht.

Diese Aufgabe wird erfindungsgemäß dadurch gelöst, daß ein Heizelement direkt am Substratträger angeordnet und über korrespondierende Kontakte - beispielsweise einem Kontaktstift mit einer Kontaktbuchse -elektrisch mit einer an einer Konsole vorgesehenen Stromversorgung verbindbar ist, wozu ein Substratträger vorzugsweise auf der Oberseite der Konsole mit einer nicht näher definierten Hubvorrichtung absetzbar ist.

Diese Vorrichtung weist eine erheblich vereinfachte Bauweise und Bedienung und mit Vorteil eine wesentliche verkürzte Aufheizzeit auf, bis ein Temperaturausgleich zwischen dem Substratträger und dem Substrat stattgefunden hat.

Weitere Ausführungsmöglichkeiten und Merkmale sind in den Unteransprüchen näher beschrieben und gekennzeichnet.

Die Erfindung läßt die verschiedensten Ausführungsmöglichkeiten zu; eine davon ist in der anhängenden Zeichnung näher dargestellt, die eine Vorrichtung zum direkten Beheizen eines auf dem Boden einer Prozeßkammer einer Vakuumschleusenanlage angeordneten, kreisscheibenförmigen Substratträgers im Schnitt zeigt, wobei das Substrat mit strichlierten Linien angedeutet ist.

Die dargestellte Vorrichtung zum direkten Beheizen eines Substratträgers 1 besteht im wesentlichen aus einer topfförmigen, nach unten geöffneten, in der Vakuumkammer A gehaltenen Konsole 1 mit einem im Zentrum ihrer Oberseite befestigten, lotrecht angeordneten Kontaktstift 2 sowie zwei Leistungszuführungen 3 und 4 zur Versorgung der Vorrichtung mit Heizstrom, wobei eine der beiden Zuführungen 3, 4 am unteren Ende des Kontaktstiftes 2 und die andere der beiden Zuführungen an der Unterseite des sich horizontal erstrekkenden Teils der Konsole 1 angeschlossen ist.

Der scheibenförmig ausgebildete Substratträger 5 ist mit einer zentral angeordneten und mit dem Kontaktstift 2 korrespondierenden Kontaktbuchse 6 versehen, an die der bifilar gewickelte und auf der Unterseite des Substratträgers 5 eingebrachte Heizleiter 7 angeschlossen ist, wobei sich der Heizleiter 7 in spiralförmigen Windungen zum Außenrand des Substratträgers 5 erstreckt, der seinerseits auf die sich horizontal erstreckende Oberseite der Konsole 1 auflegbar ist.

Zum Aufheizen des Substrats 8 wird der Substratträger 5 zusammen mit dem auf seiner Oberseite abgelegten Substrat 8 (mit einer nicht näher definierten Hubvorrichtung) so weit nach unten zu bewegt, bis der Substratträger 5 in Kontakt mit der Oberseite der Konsole 1 gelangt ist.

### Auflistung der Einzelteile

| | |
|---|---|
| 1 | Konsole |
| 2 | Kontaktstift |
| 3 | Leistungszuführung |
| 4 | Leistungszuführung |
| 5 | Substratträger |
| 6 | Kontaktbuchse |
| 7 | Heizleiter, Heizelement |
| 8 | Substrat |
| A | Boden der Vakuumkammer |

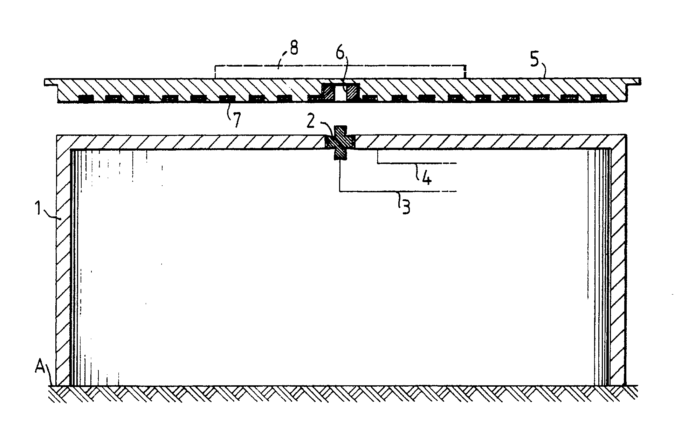

### Patentansprüche

1. Vorrichtung zum Beheizen eines Substratträgers (5) mit Hilfe einer elektrischen Widerstandsheizung in einer Anlage zur Behandlung von Substraten (8) unter Vakuum, **dadurch gekennzeichnet**, daß das Heizelement (7) direkt am Substratträger (5) angeordnet und über korrespondierende Kontakte, beispielsweise einem Kontaktstift (2), mit einer Kontaktbuchse (6) elektrisch mit einer an der Konsole (1) vorge- sehenen Stromversorgung verbindbar ist, wozu der Substratträger (5) vorzugsweise auf der Oberseite der Konsole (1) mit einer nicht näher definierten Hubvorrichtung absetzbar ist.

2.  Vorrichtung nach Anspruch 1, **dadurch gekennzeichnet**, daß der Substratträger (5) scheibenförmig ist.

3.  Vorrichtung nach Anspruch 1 oder 2, **dadurch gekennzeichnet**, daß die Grundfläche des Substratträgers (5) als Vieleck ausgeformt ist.

4.  Vorrichtung nach einem oder mehreren der vorhergehenden Ansprüche, **dadurch gekennzeichnet**, daß die mit der Oberseite der Konsole (1) in Kontakt gelangende Unterseite des Substratträgers (5) in ihrer Konfiguration derjenigen der Oberseite der Konsole (1) entspricht.

5.  Vorrichtung nach einem oder mehreren der vorhergehenden Ansprüche, **dadurch gekennzeichnet**, daß der Substratträger (5) zur Behandlung von Substraten (8) - vorzugsweise in Anlagen mit zwei oder mehreren hintereinander oder parallel geschalteten, durch Schleusen voneinander getrennten Vakuumkammern, sogenannten Vakuum-Schleusenanlagen - zum hochfrequenzbetriebenen Plasmaätzen und -beschichten vorgesehen ist.

6.  Vorrichtung nach einem oder mehreren der vorhergehenden Ansprüche, **dadurch gekennzeichnet**, daß das Heizelement (7) spiralförmig gewickelt ist und an der Unterseite des Substratträgers (1) in entsprechenden spiraligen Vertiefungen, Nuten oder Ausnehmungen eingelegt ist.

7.  Vorrichtung nach einem oder mehreren der vorhergehenden Ansprüche, **dadurch gekennzeichnet**, daß der Heizleiter (7) zur Vermeidung von störenden Magnetfeldern bifilar verlegt ist.

8.  Vorrichtung nach Anspruch 6 oder 7, **dadurch gekennzeichnet**, daß der Heizleiter (7) mit einem an der Unterseite des Substratträgers (5) zentral angeordneten elektrischen Kupplungsteil, vorzugsweise einer Kontaktbuchse (6), verbunden ist.

9.  Vorrichtung nach Anspruch 8, **dadurch gekennzeichnet**, daß die Kontaktbuchse (6) mit einem korrespondierenden, auf der Oberseite der Konsole (1) angeordneten Kontaktstift (2) verbindbar ist.

10. Vorrichtung nach Anspruch 9, **dadurch gekennzeichnet**, daß die Versorgung des Heizleiters (7) mit elektrischem Strom über die Leistungszuführungen (3, 4) erfolgt, die an der Unterseite des vorzugsweise sich horizontal erstreckenden Teils der Konsole (1) befestigt sind.

11. Vorrichtung nach Anspruch 6, **dadurch gekennzeichnet**, daß das Heizelement (7) im wesentlichen aus einem isolierten Heizdraht besteht, der in den Substratträger (5) eingelegt und mit diesem fest verbunden ist.

12. Vorrichtung nach einem oder mehreren der vorhergehenden Ansprüche, **dadurch gekennzeichnet**, daß die Konsole (1) und der Substratträger (5) aus metallischen oder keramischen Werkstoffen, vorzugsweise Cu oder Al, hergestellt sind.

Europäisches
Patentamt

EUROPÄISCHER
RECHERCHENBERICHT

Nummer der Anmeldung

EP 90 12 3729

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN, Band 10, Nr. 120 (C-343)[2177], 6. Mai 1986; & JP-A-60 245 778 (HITACHI SEISAKUSHO K.K.) 05-12-1985 * Insgesamt * | 1,2,5,6, 10,11 | C 23 C 14/54 C 23 C 16/46 |
| | - - - | | |
| A | PATENT ABSTRACTS OF JAPAN, Band 9, Nr. 254 (C-308)[1977], 11. Oktober 1985; & JP-A-60 106 968 (HITACHI SEISAKUSHO K.K.) 12-06-1985 * Insgesamt * | 1,2,5,6, 10,11 | |
| | - - - | | |
| A | GB-A-1 004 739 (INTERNATIONAL COMPUTERS & TABULATORS LTD) * Insgesamt * | 1,3,6, 10-12 | |
| | - - - | | |
| A | US-A-3 749 662 (R.E. BIEHL) * Insgesamt * | 1,2,5,6, 10,11 | |
| | - - - | | |
| A | FR-A-2 171 877 (COMMISSARIAT A L'ENERGIE ATOMIQUE) * Insgesamt * | 1,2 | RECHERCHIERTE SACHGEBIETE (Int. Cl.5) |
| | - - - - - | | C 23 C |

Der vorliegende Recherchenbericht wurde für alle Patentansprüche erstellt

| Recherchenort | Abschlußdatum der Recherche | Prüfer |
|---|---|---|
| Den Haag | 25 Juni 91 | JOFFREAU P.O. |